Europäisches Patentamt

European Patent Office

Office européen des brevets

(11) Numéro de publication: **0 256 939 B1**

# (12) FASCICULE DE BREVET EUROPEEN

(45) Date de publication de fascicule du brevet: **22.04.92**    (51) Int. Cl.⁵: $G01R\ 15/02$, $H01F\ 40/06$

(21) Numéro de dépôt: **87401847.6**

(22) Date de dépôt: **07.08.87**

(54) **Dispositif de mesure de courant.**

(30) Priorité: **11.08.86 FR 8611586**

(43) Date de publication de la demande:
**24.02.88 Bulletin 88/08**

(45) Mention de la délivrance du brevet:
**22.04.92 Bulletin 92/17**

(84) Etats contractants désignés:
**AT BE CH DE ES GB GR IT LI NL SE**

(56) Documents cités:
**DE-C- 521 886**
**FR-A- 2 044 648**
**FR-A- 2 170 303**
**FR-A- 2 538 556**

(73) Titulaire: **UNIVERSAL TECHNIC**
**5, Passage Fréquel**
**F-75020 Paris(FR)**

(72) Inventeur: **Landre, Bernard**
**17 Rue Planchat**
**F-75020 Paris(FR)**

(74) Mandataire: **Fruchard, Guy et al**
**CABINET BOETTCHER 23, rue la Boétie**
**F-75008 Paris(FR)**

Rank Xerox (UK) Business Services

# Description

La présente invention concerne des dispositifs de mesure de courant ouvrants et plus particulièrement des transformateurs de courant à implantation permanente ou semi-permanente.

On connait de nombreux types de dispositifs de mesure de courant ouvrants. Le type le plus répandu est la pince ampèremétrique qui est mise en place pour une mesure instantanée du courant passant dans un câble, puis retirée après avoir effectué la mesure. Lorsque l'on désire effectuer une mesure permanente, ou semi-permanente, du courant traversant un conducteur, il est généralement peu souhaitable d'utiliser une pince ampèremétrique. En effet, comme décrit dans le document FR-A-2.044.648, le circuit magnétique ouvrant d'une pince ampèremétrique est généralement refermé par un organe élastique tel qu'un ressort et, en utilisation permanente, la pince risque de s'ouvrir sous l'effet des vibrations auxquelles elle est soumise. De plus, une pince ampèremétrique est généralement équipée de poignées dont l'encombrement est incompatible avec les impératifs d'une installation électrique complexe.

Lorsqu'un transformateur de courant doit être installé de façon permanente, ou semi-permanente, il comporte généralement un circuit magnétique en deux parties articulées l'une avec l'autre à la façon d'une pince et maintenues serrées l'une contre l'autre par un boulon s'étendant perpendiculairement aux faces extrêmes des parties de circuit magnétique. Ces dispositifs sont peu maniables en raison de l'encombrement important qu'ils présentent en position ouverte. De plus, le serrage des boulons est généralement difficile à contrôler et entraîne un gauchissement des surfaces d'appui, ce qui provoque une perturbation de la transmission du flux magnétique au niveau des entrefers entre les parties de circuit.

On connait également du document DE-C-521 886 un transformateur de courant comportant un circuit magnétique torique coulissant dans un boîtier. Toutefois, dans ce document, le circuit magnétique est simplement guidé pour coulisser coaxialement au boitier mais ne comporte aucun organe pour maintenir les parties de circuits magnétique appliquées l'une contre l'autre.

Un but de la présente invention est de proposer un dispositif de mesure de courant de structure simple, de mise en place facile et assurant une bonne transmission du flux magnétique.

En vue de la réalisation de ce but, on prévoit selon un premier mode de réalisation de l'invention un dispositif de mesure comportant un circuit magnétique annulaire comprenant une première et une seconde partie de circuit magnétique séparées ayant des extrémités adaptées à venir en regard pour former un circuit magnétique fermé, un boîtier entourant au moins la première partie de circuit magnétique, des moyens de détection d'un flux magnétique dans le circuit magnétique et des moyens de blocage des deux parties de circuit magnétique l'une contre l'autre, caractérisé en ce que les moyens de blocage comportent des portions d'accrochage portées par le boîtier et s'étendant au-delà des extrémités de la première partie de circuit magnétique sur un côté extérieur de celles-ci et en ce que la seconde partie de circuit magnétique est montée pour pivoter sur des ergots de pivotement portés par les portions d'accrochage, entre une première position où les extrémités de la seconde partie de circuit magnétique ne sont pas en regard des extrémités de la première partie de circuit magnétique et où la seconde partie de circuit magnétique est mobile latéralement pour la dégager des ergots de pivotement, et une seconde position où la seconde partie de circuit magnétique a ses extrémités en appui sur les extrémités de la première partie du circuit magnétique et où la seconde partie de circuit magnétique est immobilisée, le dispositif comportant en outre des moyens pour permettre un déplacement relatif des extrémités de la première partie de circuit magnétique par rapport aux ergots de pivotement.

Ainsi, la fermeture du dispositif de mesure de courant est obtenue simplement en engageant latéralement la seconde partie de circuit magnétique sur les moyens de pivotement, puis en la faisant pivoter sur elle-même pour amener ses extrémités en regard des extrémités de la première partie de circuit magnétique.

Selon un aspect avantageux de ce mode de réalisation, les moyens pour permettre un déplacement relatif de l'extrémité de la première partie de circuit magnétique par rapport aux ergots de pivotement comprennent au moins un organe élastique disposé entre le boîtier et la première partie de circuit magnétique en un point opposé aux extrémités de la première partie de circuit magnétique de façon à exercer un effort sensiblement identique sur chacune des extrémités de la première partie de circuit magnétique. Ainsi, la première partie de circuit magnétique est repoussée en permanence vers la seconde partie de circuit magnétique sans produire de gauchissement au niveau des surfaces d'entrefers.

Selon un autre aspect avantageux de ce mode de réalisation de l'invention, les moyens pour permettre un déplacement relatif des extrémités de la première partie de circuit magnétique par rapport aux ergots de pivotement comprennent une came disposée sur un axe entre le boîtier et la première partie de circuit magnétique en un point opposé aux extrémités de la première partie de circuit magnétique, de façon à exercer un effort sensiblement identique sur chacune des extrémités de la première partie de circuit magnétique. Ainsi, on contrôle exactement la pression entre les surfaces d'entrefers sans créer de gauchissement entre celles-ci.

Selon un autre mode de réalisation de l'invention, le dispositif de mesure de courant comporte un circuit magnétique annulaire comprenant une première et une seconde partie de circuit magnétique séparées ayant des extrémités adaptées à venir en regard pour former un circuit magnétique fermé, un boîtier entourant au moins la première partie de circuit magnétique, des moyens de détection d'un flux magnétique dans le circuit magnétique, caractérisé en ce que le boîtier comporte une surface de guidage en contact avec la première partie de circuit magnétique sur une partie du pourtour de celle-ci et en ce que les parties de circuit magnétique sont montées pour pivoter selon un mouvement de coulissement par rapport à la surface de guidage jusqu'à ce que la seconde partie de circuit magnétique vienne en contact d'une surface d'appui portée par le boîtier.

Ainsi, après avoir disposé des extrémités de la seconde partie de circuit magnétique en regard des extrémités de la première partie de circuit magnétique, on déplace aisément l'ensemble du circuit magnétique vers la position de blocage en agissant sur la première partie de circuit magnétique.

D'autre caractéristiques et avantages de l'invention apparaîtront encore à la lecture de la description qui suit de plusieurs mode de réalisation particuliers de l'invention en liaison avec les dessins ci-joints parmi lesquels :

- la figure 1 est une vue en élévation, partiellement écorchée, d'un premier mode de réalisation de l'invention,
- la figure 2 est une vue en coupe selon la ligne II-II de la figure 1,
- la figure 3 est une vue en coupe partielle analogue à celle de la figure 2 pour une position différente du dispositif,
- la figure 4 est une vue en élévation écorchée partielle d'une variante de réalisation du mode de réalisation de la figure 1,
- la figure 5 est une vue en coupe selon la ligne V-V de la figure 4,
- la figure 6 est une vue en élévation partiellement écorchée d'un second mode de réalisation de l'invention,
- la figure 7 est une vue analogue à celle de la figure 6 pour une position différente du dispositif,
- la figure 8 est une vue en élévation de l'avant du dispositif de la figure 6.

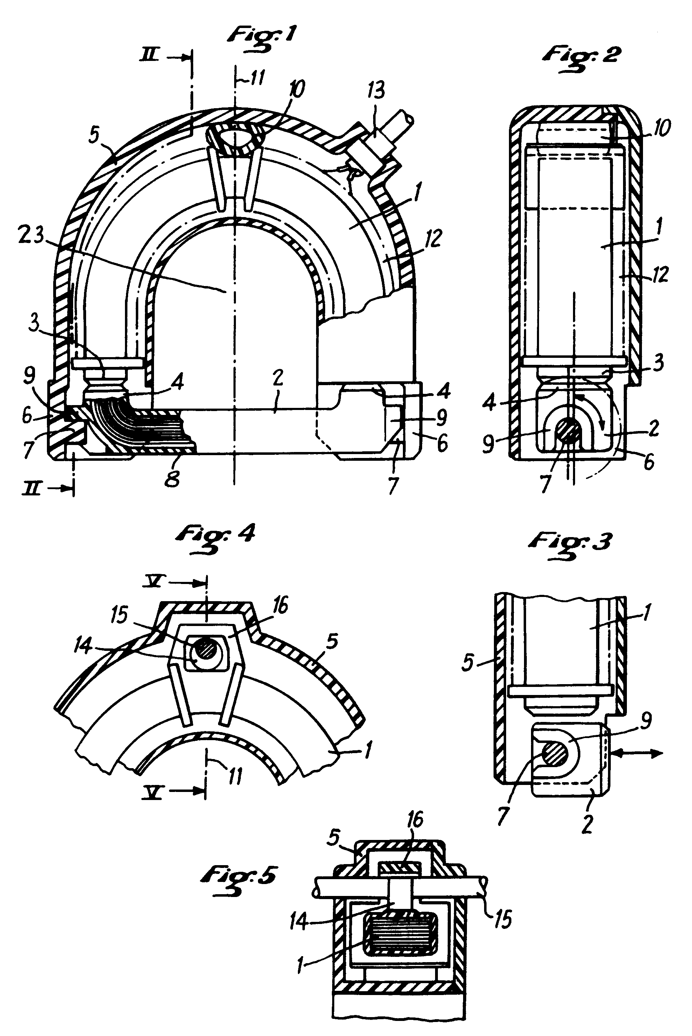

En référence aux figures 1 à 3, le premier mode de réalisation du dispositif de mesure du courant selon l'invention comporte un circuit magnétique annulaire comprenant une première partie de circuit magnétique 1 et une seconde partie de circuit magnétique 2 séparées. La première partie de circuit magnétique 1 est en forme de U et comporte des extrémités 3. La seconde partie de circuit magnétique 2 est également en forme de U, avec des branches latérales très courtes et comporte des extrémités 4 de même écartement que les extrémités 3 de la première partie de circuit magnétique, de sorte que des extrémités 3 et 4 sont adaptées à venir en regard pour former un circuit magnétique fermé.

Un boîtier 5 entoure la première partie de circuit magnétique et comporte des portions d'accrochage 6 s'étendant au-delà des extrémités de la première partie de circuit magnétique 1 sur un côté extérieur de celle-ci. Du côté intérieur des portions d'accrochage 6, le boîtier comporte des ergots de pivotement 7 en saillie vers l'intérieur du boîtier.

La seconde partie de circuit magnétique 2 comporte un gainage 8 formant, au voisinage des coudes de la seconde partie de circuit magnétique, des cavaliers 9 adaptés à venir s'engager sur les ergots de pivotement 7.

La première partie de circuit magnétique 1 est montée mobile dans le boîtier 5 et est sollicitée vers les portions d'accrochage 6 par un organe élastique 10, par exemple un morceau de tube en caoutchouc, disposée entre le boîtier 5 et la première partie de circuit magnétique en un point opposé aux extrémités 3 de la première partie de circuit magnétique. Dans le mode de réalisation illustré, l'organe élastique 10 est disposé selon l'axe de symétrie 11 de la première partie de circuit magnétique et transmet ainsi un effort identique sur chacune des extrémités 3 de la première partie de circuit magnétique.

Le dispositif comporte d'une façon classique des moyens de détection d'un flux magnétique dans le circuit magnétique formés ici par un bobinage 12 symbolisé en trait mixte sur les figures et dont les extrémités sont reliées à une borne 13 pour transmettre le signal électromagnétique obtenu à un appareil de mesure.

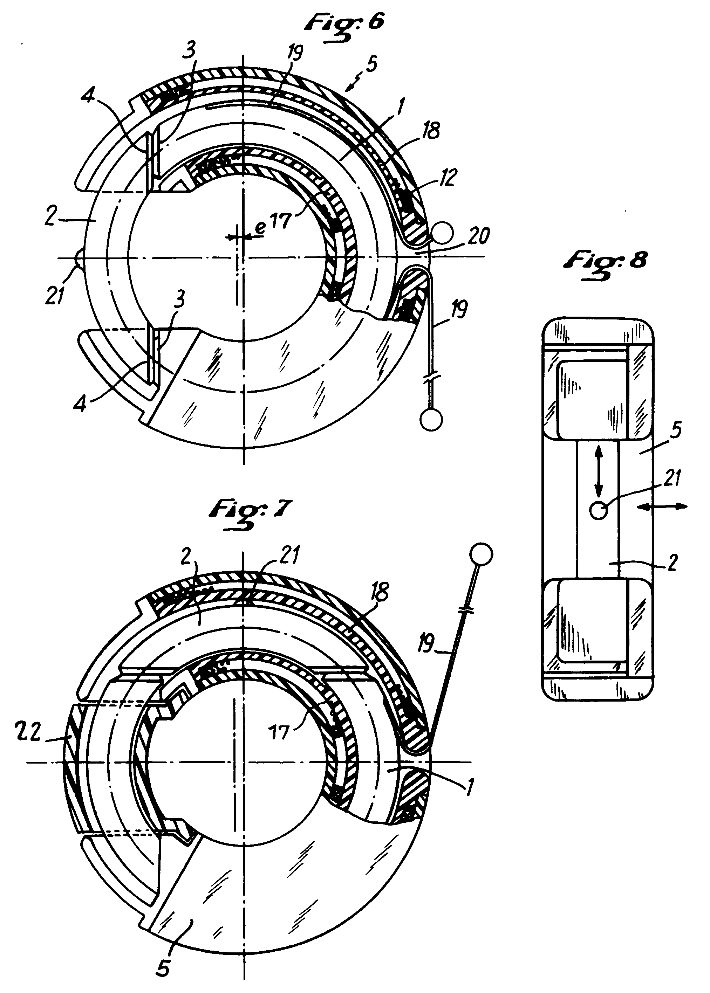

La mise en place du dispositif de mesure selon l'invention est effectuée de la façon suivante : la seconde partie de circuit magnétique étant retirée, la première partie de circuit magnétique 1 est engagée autour d'un conducteur afin que celui-ci soit disposé dans l'espace central 23. La seconde partie de circuit magnétique 2 est ensuite engagée latéralement, comme représenté sur la figure 3, les cavaliers 9 venant s'engager sur les ergots de pivotement 7. Dans cette première position, les extrémités 4 de la seconde partie de circuit magnétique 2 ne sont pas en regard des extrémités 3

de la première partie de circuit magnétique 1 et la seconde partie de circuit magnétique 2 reste mobile latéralement pour la dégager des moyens de pivotement. A partir de cette première position, la seconde partie de circuit magnétique 2 est pivotée autour de l'axe des ergots 7 comme indiqué par la flèche de la figure 2 et vient dans une seconde position où ses extrémités 4 sont en appui sur les extrémités 3 de la première partie de circuit magnétique. Lors du mouvement de pivotement de la seconde partie de circuit magnétique 2, la première partie de circuit magnétique 1 est repoussée à l'encontre de la force exercée par l'organe élastique 10 jusqu'au moment où les extrémités 4 de la seconde partie de circuit magnétique sont en appui contre les extrémités 3 de la première partie de circuit magnétique. On constate à ce propos que l'organe élastique 10 forme des moyens permettant un déplacement relatif des extrémités de la première partie de circuit magnétique par rapport aux moyens de pivotement et les ergots de pivotement 7 forment un organe d'appui porté par le boîtier et maintenant la seconde partie de circuit magnétique contre la première partie de circuit magnétique.

Les figures 4 et 5 illustrent une variante de réalisation dans laquelle l'organe élastique 10 est remplacé par une came 14 disposée sur un axe 15 entre le boîtier 5 et la première partie de circuit magnétique 1 sensiblement sur l'axe de symétrie 11 de la première partie de circuit magnétique 1. La came 14 est entourée par une bague 16 solidaire de la première partie de circuit magnétique. La position de la came 14 est commandée en faisant tourner l'axe 15. Lors de la mise en place de la seconde partie de circuit magnétique 2, la came 14 est tournée pour que sa partie la plus large vienne en appui sur la bague 16 vers l'arrière du boîtier. La première partie de circuit magnétique 1 est alors tirée vers l'arrière et il existe donc un espace suffisant entre les extrémités 3 de la première partie de circuit magnétique et les ergots de pivotement 7 pour permettre un pivotement aisé de la seconde partie de circuit magnétique 2. Lorsque les extrémités 4 de la seconde partie de circuit magnétique 2 sont en regard des extrémités 3 de la première partie de circuit magnétique, la came 14 est tournée pour que sa partie la plus large vienne en appui sur l'arrière de la première partie de circuit magnétique 1, comme illustré par la figure 4. Dans cette position, la came 14 transmet un effort identique sur chacune des extrémités de la première partie de circuit magnétique. On remarque qu'avec ce mode de réalisation il est possible d'assurer un verrouillage du dispositif de mesure en position fermée par un blocage de la rotation de l'arbre 15. Ce blocage peut par exemple être obtenu en prévoyant sur l'arbre 15 et sur le boîtier 5 des languettes s'étendant latéralement et maintenues associées l'une à l'autre par un plombage.

Les figures 6 à 8 illustrent un second mode de réalisation de l'invention. Dans ce mode de réalisation, le circuit magnétique est torique. La première partie de circuit magnétique 1 est formée par une portion de tore en C et la seconde partie de circuit magnétique 2 est formée par une portion de tore complémentaire. Le boîtier 5 comprend une cloison interne cylindrique 17 et une cloison externe 18 également cylindrique, mais présentant par rapport à la cloison interne 17 un excentrement e. Le diamètre de la cloison interne 17 est voisin de celui de la face interne de la première partie de circuit magnétique de sorte que la cloison interne 17 forme une surface de guidage en contact avec la première partie de circuit magnétique sur une partie du pourtour de celle-ci. Les parties de circuit magnétique sont montées pour pivoter selon un mouvement de coulissement par rapport à la cloison interne 17. Le boîtier 5 a lui-même une forme de C et la cloison externe 18 entoure donc la première partie de circuit magnétique du côté externe de celle-ci. Le dispositif comporte en outre des moyens d'entraînement de la première partie de circuit magnétique. Ces moyens d'entraînement sont formés par des rubans 19 fixés à une extrémité à la périphérie de la première partie de circuit magnétique et débouchant à l'extérieur du boîtier par une lumière 20 dans la paroi externe 18 du boîtier.

La seconde partie de circuit magnétique 2 comporte un téton d'appui 21 en saillie vers l'extérieur.

Pour la mise en service de ce deuxième mode de réalisation, la première partie du circuit magnétique 1 est tout d'abord déplacée en agissant sur l'un des rubans 19 pour qu'elle prenne une position symétrique par rapport à l'ouverture du boîtier comme représenté sur la figure 6. Dans cette position, la deuxième partie de circuit magnétique 2 est engagée latéralement pour que ses extrémités 4 soient en regard des extrémités 3 de la première partie de circuit magnétique. L'un des rubans 19 est alors tiré pour faire pivoter l'ensemble du circuit magnétique autour de son axe. Dans ce mouvement, la seconde partie de circuit magnétique pénètre dans le boîtier et, en raison de l'excentrement de la cloison 18 par rapport à la cloison 17, l'ergot 21 vient progressivement en appui sur la cloison 18, de sorte que la seconde partie de circuit magnétique 2 est maintenue fermement contre la première partie de circuit magnétique 1.

De même que dans le mode de réalisation précédent, le dispositif peut être mis en place de façon inviolable en supprimant l'un des deux rubans d'entraînement 19 et en disposant autour de la seconde partie de circuit magnétique 2, préalablement à sa mise en place en regard de la première partie de circuit magnétique, un manchon 22 (figure 7) ayant des extrémités venant en coïncidence avec les extrémités du boîtier 5. Lorsqu'une traction est exercée sur le ruban 19 restant, l'ensemble du circuit magnétique pivote autour de son axe pour prendre la position illustrée par la figure 7 et le manchon 22 est alors emprisonné entre les extrémités du boîtier 5. Dans cette position, il n'est plus possible d'accéder à la première partie de circuit magnétique et le dispositif est donc verrouillé de façon inviolable.

Bien entendu l'invention n'est pas limitée aux modes de réalisation décrits ci-dessus et on peut y apporter des variantes de réalisation sans sortir du cadre de l'invention. En particulier, dans le cas du premier mode de réalisation, on peut prévoir de réaliser des ergots de pivotement non pas sur la portion d'accrochage 6 mais au contraire sur la seconde partie de circuit 2, ces ergots de pivotements étant alors engagés dans des lumières réalisées dans les portions d'accrochage 6 perpendiculairement au plan de la première partie de circuit 1. On peut également remplacer l'organe élastique unique 10 par plusieurs organes élastiques séparés disposés de façon symétrique par rapport à la première partie de circuit magnétique.

Dans le cas du second mode de réalisation, on peut prévoir de remplacer l'excentrement des cloisons 17 et 18 par un évasement de la cloison 18 au voisinage de l'ouverture du boîtier. On peut également prévoir un circuit magnétique elliptique disposé entre des cloisons cylindriques, la seconde partie de circuit magnétique étant alors une portion de l'ellipse découpée au voisinage d'une des extrémités du grand axe de l'ellipse.

**Revendications**

1. Dispositif de mesure de courant comportant un circuit magnétique annulaire comprenant une première et une seconde partie de circuit magnétique séparées (1,2) ayant des extrémités (3, 4) adaptées à venir en regard pour former un circuit magnétique fermé, un boîtier (5) entourant au moins la première partie (1) de circuit magnétique, des moyens de détection (12) d'un flux magnétique dans le circuit magnétique et des moyens de blocage des deux parties (1,2) de circuit magnétique l'une contre l'autre, caractérisé en ce que les moyens de blocage comportent des portions d'accrochage (6) portées par le boîtier (5) et s'étendant au-delà des extrémités de la première partie (1) de circuit magnétique sur un côté extérieur de celles-ci et en ce que la seconde partie (2) de circuit magnétique est montée pour pivoter sur des ergots de pivotement (7) portés par les portions d'accrochage (6), entre une première position où les extrémités (4) de la seconde partie (2) de circuit magnétique ne sont pas en regard des extrémités (3) de la première partie (1) de circuit magnétique et où la seconde partie (2) de circuit magnétique est mobile latéralement pour la dégager des ergots de pivotement (7), et une seconde position où la seconde partie (2) de circuit magnétique a ses extrémités (4) en appui sur les extrémités (3) de la première partie (1) du circuit magnétique et où la seconde partie (2) de circuit magnétique est immobilisée, le dispositif comportant en outre des moyens (10, 14) pour permettre un déplacement relatif des extrémités (3) de la première partie (1) de circuit magnétique par rapport aux ergots de pivotement (7).

2. Dispositif de mesure de courant selon la revendication 1 caractérisé en ce que les moyens pour permettre un déplacement des extrémités (3) de la première partie (1) de circuit magnétique par rapport aux ergots de pivotement (7) comprennent au moins un organe élastique (10) disposé entre le boîtier (5) et la première partie (1) de circuit magnétique en un point opposé aux extrémités (3) de la première partie (1) de circuit magnétique, de façon à exercer un effort sensiblement identique sur chacune des extrémités (3) de la première partie (1) de circuit magnétique.

3. Dispositif de mesure de courant selon la revendication 1, caractérisé en ce que les moyens pour permettre un déplacement relatif des extrémités (3) de la première partie (1) de circuit magnétique par rapport aux ergots de pivotement (7) comprennent une came (14) disposée sur un axe (15) entre le boîtier (5) et la première partie (1) de circuit magnétique en un point opposé aux extrémités (3) de la première partie (1) de circuit magnétique de façon à exercer un effort sensiblement identique sur chacune des extrémités (3) de la première partie (1) de circuit magnétique.

4. Dispositif de mesure de courant selon la revendication 3, caractérisé en ce que la came (14) est entourée par une bague (16) solidaire de la première partie (1) de circuit magnétique.

5. Dispositif de mesure de courant comportant un circuit magnétique annulaire comprenant une première et une seconde partie de circuit magnétique séparées (1,2) ayant des extrémités (3,4) adaptées à venir en regard pour former un circuit magnétique fermé, un boîtier (5) entourant au moins la première partie (1) de circuit magnétique, des moyens de détection (12) d'un flux magnétique dans le circuit magnétique caractérisé en ce que le boîtier (5) comporte une surface de guidage (17) en contact avec la première partie (1) de circuit magnétique sur une partie du pourtour de celle-ci et en ce que les parties (1,2) de circuit magnétique sont montées pour pivoter selon un mouvement de coulissement par rapport à la surface de guidage (17) jusqu'à ce que la seconde partie (2) de circuit magnétique vienne au contact d'une surface d'appui (18) portée par le boîtier (5).

6. Dispositif de mesure de courant selon la revendication 5 caractérisé en ce que les parties (1,2) de circuit magnétiques sont des sections d'un tore, et en ce que la surface de guidage (17) et la surface d'appui (18) sont des surfaces cylindriques présentant un excentrement (e).

7. Dispositif de mesure de courant selon la revendication 5 ou la revendication 6, caractérisée en ce qu'il comporte des moyens d'entraînement (19) de la première partie (1) de circuit magnétique.

8. Dispositif de mesure de courant selon la revendication 7, caractérisé en ce que le boîtier (5) a une forme de C entourant la première partie (1) de circuit magnétique au moins d'un côté externe de celle-ci et en ce que les moyens d'entraînement comportent des rubans (19) fixés à une extrémité de la périphérie de la première partie (1) de circuit magnétique et débouchant à l'extérieur du boîtier (5) par une lumière (20) dans une paroi externe (18) du boîtier (5).

9. Dispositif de mesure de courant selon la revendication 8, caractérisé en ce qu'il comporte un manchon (22) ayant des extrémités venant en coïncidence avec les extrémités du boîtier (5).

10. Dispositif de mesure de courant selon l'une des revendications 6 à 9 caractérisé en ce que la seconde partie (2) de circuit magnétique comporte un téton d'appui (21) en saillie sur un côté tourné vers la surface d'appui (18) du boîtier (5).

**Claims**

1. A current-measuring device comprising an annular magnetic circuit having separate first and second magnetic circuit portions (1,2) with ends (3,4) suitable for coming face-to-face to form a closed magnetic circuit, a housing (5) surrounding at least the first portion (1) of the magnetic circuit, magnetic flux detection means (12) for detecting a magnetic flux in the magnetic circuit, and locking means for locking the two magnetic circuit portions against each other, the device being characterized in that the locking means comprise fastening portions (6) carried by the housing and extending beyond the ends of the first magnetic circuit portion on respective outer sides thereof, and in that the second magnetic circuit portion (2) is mounted to pivot relative to pivot pegs (7) carried by the fastening portions, between a first position in which the ends (4) of the second magnetic circuit portion are not face-to-face with the ends (3) of the first magnetic circuit portion and where the second magnetic circuit portion is laterally displaceable for the purpose of disengaging from the pivot means, and a second position where the second magnetic circuit portion has its ends pressed against the ends of the first magnetic circuit portion and where the second magnetic circuit portion is immobilized, the device further including means (10, 14) to enable the ends of the first magnetic circuit portion to move relative to the pivot means.

2. A current-measuring device according to claim 1, characterized in that the means for enabling the ends (3) of the first magnetic circuit portion to move relative to the pivot means comprise at least one resilient member (10) disposed between the housing and the first magnetic circuit portion at a point opposite to the ends of the first magnetic circuit portion in such a manner as to exert a substantially identical force on each of the ends of the first magnetic circuit portion.

3. A current-measuring device according to claim 1, characterized in that the means for enabling the ends of the first magnetic circuit portion to move relative to the pivot means comprise a cam (14) disposed on a shaft (15) between the housing and the first magnetic circuit portion at a point opposite to the ends of the first magnetic circuit portion so as to exert a substantially identical force on each of the ends of the first magnetic circuit portion.

4. A current-measuring device according to claim 3, characterized in that the cam (14) is surrounded by a ring (16) which is fixed to the first magnetic circuit portion.

5. A current-measuring device comprising an annular magnetic circuit having separate first and second magnetic circuit portions (1, 2) with ends (3, 4) suitable for coming face-to-face to form a closed magnetic circuit, a housing (5) surrounding at least the first portion (1) of the magnetic circuit, magnetic flux detection means (12) for detecting a magnetic flux in the magnetic circuit characterized in that the housing includes a guide surface (17) in contact with the first magnetic circuit portion over a portion of its periphery, and in that the magnetic circuit portions are mounted to pivot with a sliding motion relative to the guide surface (17) until the second magnetic circuit portion (2) contacts a bearing surface (18) carried by the housing.

6. A current-measuring device according to claim 5 characterized in that the magnetic circuit portions are torus portions, and in that the guiding surface (17) and the bearing surface (18) are cylindrical surfaces having an eccentricity e.

7. A current-measuring device according to claim 5 or claim 6 characterized in that it includes drive means (19) for driving the first magnetic circuit portion.

8. A current-measuring device according to claim 7, characterized in that the housing is C-shaped and surrounds the first magnetic circuit portion around at least one outer side thereof and in that the drive means include tapes (19) fixed to one end of the periphery of the first magnetic circuit portion and leaving the housing via a slot (20) in the outside wall (18) of the housing.

9. A current-measuring device according to claim 8, characterized in that it includes a sleeve (22) having ends which coincide with the ends of the housing.

10. A current-measuring device according to any one of claims 6 to 9, characterized in that the second magnetic circuit portion includes a bearing stud (21) projecting from a side turned towards the bearing surface (18) of the housing.

**Patentansprüche**

1. Vorrichtung zur Strommessung mit einem ringförmigen Magnetkreis, welcher einen ersten und einen zweiten, jeweils voneinander getrennten Magnetkreisabschnitt (1, 2) umfaßt, deren Enden (3, 4) so zueinander ausrichtbar sind, daß ein geschlossener Magnetkreis gebildet wird, ferner mit einem Gehäuse (5), welches zumindest den ersten Magnetkreisabschnitt (1) umgibt, einer Detektoreinrichtung (12) für die Erkennung eines Magnetflusses im Magnetkreis und mit Mitteln zum gegenseitigen Verriegeln der beiden Magnetkreisabschnitte (1, 2) miteinander, dadurch **gekennzeichnet,** daß die Verriegelungsmittel Kupplungsabschnitte (6) umfassen, die am Gehäuse (5) angeordnet sind und die über die Enden des ersten Magnetkreisabschnittes (1) an einer Außenseite derselben überstehen, und daß der zweite Magnetkreisabschnitt (2) auf an den Kupplungsabschnitten (6) angeordneten Schwenkzapfen (7) zwischen einer ersten Stellung, bei der die Enden (4) des zweiten Magnetkreisabschnittes (2) zu den Enden (3) des ersten Magnetkreisabschnittes (1) nicht ausgerichtet sind und bei der der zweite Magnetkreisabschnitt (2) seitlich bewegbar und außer Eingriff mit den Schwenkzapfen (7) bringbar ist, sowie einer zweiten Stellung, bei der der zweite Magnetkreisabschnitt (2) seine Enden (4) an die Enden (3) des ersten Magnetkreisabschnittes (1) anlegt und bei der der zweite Magnetkreisabschnitt (2) festgelegt ist, schwenkbar angeordnet ist, wobei die Vorrichtung außerdem Mittel (10, 14) aufweist, welche eine Verschiebung der Enden (3) des ersten Magnetkreisabschnittes (1) relativ zu den Schwenkzapfen (7) ermöglichen.

2. Vorrichtung zur Strommessung nach Anspruch 1, dadurch **gekennzeichnet,** daß die Mittel, welche eine Verschiebung der Enden (3) des ersten Magnetkreisabschnittes (1) relativ zu den Schwenkzapfen (7) ermöglichen, wenigstens ein elastisches Organ (10) umfassen, welches zwischen dem Gehäuse (5) und dem ersten Magnetkreisabschnitt (1) an einem den Enden (3) des ersten Magnetkreisabschnittes (1) abgewandten Punkt angeordnet ist derart, daß es eine im wesentlichen gleiche Kraftwirkung auf jedes der Enden (3) des ersten Magnetkreisabschnittes (1) ausübt.

3. Vorrichtung zur Strommessung nach Anspruch 1, dadurch **gekennzeichnet,** daß die Mittel, welche eine Verschiebung der Enden (3) des ersten Magnetkreisabschnittes (1) relativ zu den Schwenkzapfen (7) ermöglichen, einen Nocken (14) umfassen, welcher auf einer Drehachse (15) zwischen dem Gehäuse (5) und dem ersten Magnetkreisabschnitt (1) an einem den Enden (3) des ersten Magnetkreisabschnittes (1) abgewandten Punkt angeordnet ist derart, daß er eine im wesentlichen gleiche Kraftwirkung auf jedes der Enden (3) des ersten Magnetkreisabschnittes (1) ausübt.

4. Vorrichtung zur Strommessung nach Anspruch 3, dadurch **gekennzeichnet,** daß der Nocken (14) von einem am ersten Magnetkreisabschnitt (1) befestigten Ring (16) umgeben ist.

5. Vorrichtung zur Strommessung mit einem ringförmigen Magnetkreis, welcher einen ersten und einen zweiten jeweils vom anderen getrennten Magnetkreisabschnitt (1, 2) umfaßt, deren Enden (3, 4) so zueinander ausrichtbar sind, daß ein geschlossener Magnetkreis gebildet wird, ferner mit einem Gehäuse (5), welches zumindest den ersten Magentkreisabschnitt (1) umgibt, und mit einer Detektoreinrichtung (12) für die Erkennung eines Magnetflusses im Magnetkreis, dadurch **gekennzeichnet,** daß das Gehäuse (5) eine Führungsfläche (17) hat, die an dem ersten Magnetkreisabschnitt (1) auf einem Umfangsabschnitt desselben anliegt, und daß die Magnetkreisabschnitte (1, 2) durch eine Verschiebebewegung gegenüber der Führungsfläche (17) verschwenkbar sind, bis der zweite Magnetkreisabschnitt (2) an einer Stützfläche (18) am Gehäuse (5) zur Anlage kommt.

6. Vorrichtung zur Strommessung nach Anspruch 5, dadurch **gekennzeichnet,** daß die Magnetkreisabschnitte (1, 2) Torusabschnitte sind und daß die Führungsfläche (17) und die Stützfläche (18) Zylinderflächen mit einer Exzentrizität (e) sind.

7. Vorrichtung zur Strommessung nach Anspruch 5 oder Anspruch 6, dadurch **gekennzeichnet,** daß sie Mittel (19) für den Verschiebeantrieb des ersten Magnetkreisabschnittes (1) hat.

8. Vorrichtung zur Strommessung nach Anspruch 7, dadurch **gekennzeichnet,** daß das Gehäuse (5) die Form eines C hat, welches den ersten Magnetkreisabschnitt zumindest an einer Außenseite desselben umgibt, und daß die Mittel für den Verschiebeantrieb Bänder (19) umfassen, die an einem Ende der Peripherie des ersten Magnetkreisabschnittes (1) befestigt sind und durch eine Öffnung (20) in einer Außenwand (18) des Gehäuses (5) nach außen geführt sind.

9. Vorrichtung zur Strommessung nach Anspruch 8, dadurch **gekennzeichnet,** daß sie eine Ringmuffe (22) aufweist, deren Enden mit den Enden des Gehäuses (5) zusammenfallen.

10. Vorrichtung zur Strommessung nach einem der Ansprüche 6 bis 9, dadurch **gekennzeichnet,** daß der zweite Magnetkreisabschnitt (2) einen Stützvorsprung (21) aufweist, welcher auf einer der Stützfläche (18) des Gehäuses (5) zugewandten Seite vorsteht.

Fig. 1

Fig. 2

Fig. 4

Fig. 3

Fig. 5

Fig: 6

Fig: 7

Fig: 8